(19) Europäisches Patentamt
European Patent Office
Office européen des brevets

(11) **EP 2 362 234 B1**

(12) **FASCICULE DE BREVET EUROPEEN**

(45) Date de publication et mention de la délivrance du brevet:
**07.11.2018 Bulletin 2018/45**

(51) Int Cl.:
***G01R 31/36*** (2006.01)

(21) Numéro de dépôt: **11290033.7**

(22) Date de dépôt: **20.01.2011**

(54) **Procédé non intrusif de détermination de l'impédance électrique d'une batterie**

Nicht intrusives Verfahren zur Bestimmung der elektrischen Impedanz einer Batterie

Non-intrusive method for determination of the electrical impedance of a battery

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.02.2010 FR 1000778**

(43) Date de publication de la demande:
**31.08.2011 Bulletin 2011/35**

(73) Titulaire: **IFP Energies nouvelles 92500 Rueil-Malmaison (FR)**

(72) Inventeurs:
• **Mingant, Rémy 38200 Vienne (FR)**
• **Sauvant-Moynot, Valérie 69006 Lyon (FR)**
• **Bernard, Julien 69600 Oullins (FR)**

(74) Mandataire: **IFP Energies nouvelles Rond-point de l'échangeur de Solaize BP3 69230 Solaize (FR)**

(56) Documents cités:
**CA-A1- 2 488 564          US-A1- 2007 257 681 US-A1- 2008 100 298**

• **N. Fliege: "Systemtheorie", 1 mars 2001 (2001-03-01), B. G. Teubner, Stuttgart, XP002604983, ISBN: 3-519-06140-6 pages 216-217, * le document en entier ***
• **BLANKE H ET AL: "Impedance measurements on lead-acid batteries for state-of-charge, state-of-health and cranking capability prognosis in electric and hybrid electric vehicles", JOURNAL OF POWER SOURCES, ELSEVIER SA, CH LNKD-DOI:10.1016/J.JPOWSOUR.2004.10.028, vol. 144, no. 2, 15 juin 2005 (2005-06-15) , pages 418-425, XP025268856, ISSN: 0378-7753 [extrait le 2005-06-15]**

EP 2 362 234 B1

**Description**

La présente invention concerne un procédé pour déterminer l'impédance électrique d'une batterie (Plomb, Ni-MH, Li-ion...) à plusieurs fréquences d'acquisition, notamment pendant son fonctionnement dans plusieurs types d'appareils ou véhicules.

La batterie électrochimique est un des composants les plus critiques dans le cas des applications véhicules, ou le stockage de l'énergie solaire. Le fonctionnement correct de ces applications s'appuie sur un système intelligent de gestion de la batterie (BMS) qui s'occupe de faire fonctionner la batterie au meilleur compromis entre les différents niveaux de sollicitation dynamique. Ce BMS mesure plusieurs paramètres comme la tension, le courant, la température afin de déterminer l'état de la batterie.

Les réactions ayant lieu lors de la charge et la décharge d'une batterie sont en général nombreuses et complexes. Lorsqu'une réaction électrochimique est étudiée, une technique de caractérisation traditionnelle est la spectrométrie d'impédance électrique qui peut permettre de modéliser la batterie comme un système électrique simple constitué de condensateurs et de résistances en série ou en parallèle.

L'impédance d'un système est accessible par la mesure de sa réponse électrique lorsqu'il est soumis à un signal sinusoïdal. Ce signal peut être un courant sinusoïdal ou une variation de tension sinusoïdale. Soit un composant électrique ou un circuit alimenté par un courant sinusoïdal $I_o \cos(\omega t + \varphi_i)$. Si la tension à ses bornes est $V_o \cos(\omega t + \varphi_v)$, l'impédance du circuit ou du composant est définie comme un nombre complexe Z, dont le module est égal au rapport $\frac{V_o}{I_o}$ et dont l'argument est égal à $\varphi = \varphi_V - \varphi_i$ :

$$Z = \frac{V_0}{I_0} e^{j\varphi}$$

L'impédance totale d'un élément peut être également représentée par la somme complexe des valeurs $Z_{réel}$ et $Z_{imag}$ tel que [1] :

$$Z = Z_{réel} + j.Z_{imag} = \frac{V_0}{I_0}\cos\varphi + j.\frac{V_0}{I_0}\sin\varphi \qquad [1]$$

La spectroscopie d'impédance consiste à appliquer aux bornes d'une batterie un signal sinusoïdal multifréquence pour connaître l'impédance du système à chaque fréquence.

De manière conventionnelle, deux types de représentations sont utilisées pour observer les variations d'impédance :

- la représentation de Nyquist (diagramme représentant en abscisse les parties réelles, et en ordonnée la partie imaginaire)

- La représentation de Bode (diagramme en échelle semi-logarithmique représentant en règle générale à la fois le module de Z (|Z|), et également la phase, en fonction de la fréquence).

Pour obtenir des spectres d'impédance, on connaît également des méthodes basées sur des outils de "traitement du signal" permettant de passer d'un signal temporel à un signal fréquentiel, telles que la transformation en séries de Fourier, et la transformation de Laplace. Les principales méthodes se basent sur l'application de signaux sinusoïdaux superposés, et également sur l'analyse des bruits (notamment bruit blanc).

Une des méthodes permettant de déterminer l'impédance d'un système par les outils d'analyse harmonique est l'utilisation d'un signal entrant (U ou I) composé d'une somme de sinusoïdes. Ce signal en analyse harmonique présente plusieurs raies distinctes représentatives de la fréquence des sinusoïdes.

Ainsi, par cette méthode, plusieurs fréquences peuvent être analysées en même temps ce qui représente un gain de temps considérable dans l'analyse.

L'analyse par bruit est également utilisée pour déterminer l'impédance d'un système. Le bruit blanc par exemple est un ensemble de signaux aléatoires qui peut être décrit dans le domaine fréquentiel par une densité spectrale de puissance constante. Ainsi, à un instant donné, toutes les fréquences possibles sont superposées, et non seulement quelques unes. Cette méthode est donc encore plus rapide que la précédente.

Cependant, toutes ces méthodes sont basées sur l'application d'un signal particulier au système électrochimique de stockage d'énergie électrique dont on souhaite déterminer l'impédance électrique.

Ceci nécessite donc l'utilisation de moyens matériels conséquents, tel qu'un galvanostat, ce qui rend l'utilisation dans un véhicule en fonctionnement très difficile (peu de place, augmentation de la masse du véhicule, ...).

Le document US 2007/0257681 A1 divulgue un procédé et un dispositif de détermination de l'impédance électrique d'un système électrochimique de stockage d'énergie nécessitant une générateur de courant.

Le document "Impedance measurements on lead-acid batteries for state-of-charge, state-of-health and cranking capability prognosis in electric and hybrid electric vehicles", Blanke H; Bohlen O; Buller S; De Doncker R W; Fricke B; Hammouche A; Linzen D; Thele M; Sauer D U, XP025268856, divulgue une méthode et un dispositif selon le préambule des revendications 1 et 9.

Ainsi l'objet de l'invention concerne un procédé non intrusif de détermination de l'impédance électrique d'un système électrochimique de type batterie, qui consiste notamment à utiliser les mesures de tension et de courant en fonction du temps, et ce aux bornes de la batterie en fonctionnement normal, et de ses éléments, sans surimposer de signaux supplémentaires.

L'invention concerne également un dispositif pour mettre en oeuvre le procédé selon l'invention, ainsi que des systèmes, notamment un système intelligent de gestion énergétique de la batterie, comportant un tel dispositif.

Le procédé selon l'invention est fiable et facile à mettre en oeuvre par rapport aux procédés antérieurs. Il est applicable à quasiment toutes les applications batteries en service.

**Le procédé et les dispositifs selon l'invention**

Un objet de l'invention concerne un procédé de détermination de l'impédance électrique d'un système électrochimique de stockage d'énergie électrique sans surimposer de signaux supplémentaires au sein du système électrochimique. Ce procédé comporte les étapes suivantes :

- on acquiert des signaux temporels mesurant une tension et un courant aux bornes dudit système, et on transforme lesdits signaux temporels en signaux fréquentiels ;
- on réalise une segmentation desdits signaux fréquentiels en plusieurs segments ;
- pour chaque segment, on détermine une densité spectrale de puissance du signal de courant $\Psi_I(f)$, et une densité spectrale de puissance croisée des signaux de tension et de courant $\Psi_{IV}(f)$ sur chacun desdits segments, dans chaque segment, lesdites densités spectrales dépendant de la fréquence f ;
- on détermine l'impédance électrique dudit système électrochimique en calculant le rapport, dépendant de la fréquence f, d'une moyenne desdites densités spectrales de puissance $\Psi_I(f)$ et d'une moyenne desdites densités spectrales de puissance croisées $\Psi_{IV}(f)$.

Selon un mode de réalisation, on réalise au moins une deuxième segmentation des signaux fréquentiels différente de la première segmentation, de façon à traiter au moins deux fois ces signaux fréquentiels.

On peut déterminer l'impédance électrique du système électrochimique uniquement pour des fréquences ayant des densités spectrales de puissance supérieures à un seuil fixé, en appliquant un filtre sur lesdites densités spectrales de puissance $\Psi I$ et $\Psi IV$.

On peut également déterminer un indicateur pour évaluer un état interne d'une batterie ou d'un de ses éléments, à partir de l'impédance électrique.

Selon un mode de réalisation, le système électrochimique de stockage d'énergie électrique est un élément d'un pack d'une batterie. Dans ce cas, le procédé selon l'invention peut être utilisé dans un procédé pour identifier des éléments défectueux d'un pack formant une batterie, dans lequel on détermine une impédance électrique de chaque élément dudit pack au moyen du procédé selon l'invention, et on compare entre elles les impédances électriques de chacun desdits éléments. Dans ce cas également, le procédé selon l'invention peut être utilisé dans un procédé pour piloter un système d'équilibrage entre des éléments d'un pack formant une batterie, dans lequel on détermine une impédance électrique complexe de chaque élément dudit pack au moyen du procédé selon l'invention.

Enfin selon l'invention, le système électrochimique de stockage d'énergie électrique peut être en fonctionnement.

Un autre objet de l'invention concerne un dispositif de détermination de l'impédance électrique complexe d'un système électrochimique de stockage d'énergie électrique sans surimposer de signaux supplémentaires au sein du système électrochimique. Ce dispositif comporte :

- un moyen de mesure de tension aux bornes dudit système en fonction du temps t ;

- un moyen de mesure de courant aux bornes dudit système en fonction du temps t ;

- des moyens logiciels pour transformer lesdites mesures en signaux fréquentiels ;

- des moyens pour réaliser au moins une segmentation desdits signaux fréquentiels en plusieurs segments ;

- des moyens logiciels de calcul de densité spectrale de puissance du signal de courant $\Psi_I(f)$ et de densité spectrale de puissance croisée des signaux de tension et de courant $\Psi_{IV}(f)$, dans chaque segment lesdites densités spectrales dépendant de la fréquence f ; et

- des moyens logiciels de calcul de l'impédance électrique dudit système électrochimique apte à effectuer un calcul d'un rapport, dépendant de la fréquence f, d'une moyenne desdites densités spectrales de puissance $\Psi_I(f)$ et d'une moyenne desdites densités spectrales de puissance croisées $\Psi_{IV}(f)$.

Un autre objet de l'invention concerne un système d'estimation d'un état interne d'un système électrochimique de stockage d'énergie électrique, comportant :

- un dispositif selon l'invention pour déterminer l'impédance électrique complexe d'un système électrochimique de stockage d'énergie électrique ;

- une mémoire permettant de stocker une relation entre une propriété relative à l'état interne du système électrochimique et l'impédance électrique complexe du système ;

- des moyens pour calculer une propriété relative à l'état interne du système électrochimique au moyen de la relation.

Un autre objet de l'invention concerne un système intelligent de gestion d'une batterie comportant un système d'estimation d'un état interne de la batterie selon l'invention.
Un autre objet de l'invention concerne un véhicule comportant une batterie et un système intelligent de gestion d'une batterie selon l'invention.
Un autre objet de l'invention concerne un système photovoltaïque de stockage d'énergie électrique, comportant un système d'estimation de son état interne selon l'invention.
D'autres caractéristiques et avantages du procédé et des dispositifs selon l'invention, apparaîtront à la lecture de la description ci-après d'exemples non limitatifs de réalisations, en se référant aux figures annexées et décrites ci-après.

**Présentation succincte des figures**

- la figure 1 montre un profil de courant mimant les sollicitations d'une batterie de véhicule hybride en fonctionnement (intégrant des phases d'accélérations et de freinages régénératifs) ainsi que la réponse en tension de la batterie à ce profil.

- Les figures 2A et 2B montrent des spectres d'impédance d'un module de batterie de véhicule hybride obtenus à partir d'un signal type routier sans filtre de DSP (figure 2A), et avec filtre de DSP (figure 2B).

- La figure 3 illustre un spectre d'impédance d'un module de batterie de véhicule hybride obtenu à partir du procédé selon l'invention avec segmentations successives.

**Description détaillée du procédé**

La présente invention concerne un procédé non intrusif pour déterminer l'impédance électrique complexe d'un système électrochimique de stockage d'énergie électrique, tel qu'une batterie.
On appelle procédé non intrusif, un procédé permettant de déterminer l'impédance sans surimposer de signaux supplémentaires au sein du système électrochimique.
Le procédé comporte l'utilisation des seules mesures de tension U, et de courant I en fonction du temps. Le procédé est particulièrement intéressant pour étudier une batterie lors de son fonctionnement. Ces mesures sont réalisées aux bornes de la batterie et aux bornes des éléments constituant la batterie. Ce procédé comporte trois étapes.

### 1. Acquisition de signaux temporels mesurant la tension et le courant

Au sein d'un véhicule électrifié en fonctionnement, le courant I est mesuré en continue en fonction du temps t. Ce signal est noté I(t). Ces mesures sont réalisées aux bornes de la batterie ou aux bornes des éléments constituant la batterie. En effet, le courant sera le même aux bornes de la batterie et aux bornes des éléments si les éléments sont en série. En revanche, si les éléments sont montés en parallèle, le courant ne sera pas le même. Le procédé selon l'invention s'applique dans les deux configurations. On note également, que le procédé selon l'invention s'applique quels que soient les niveaux de courants. On mesure également la tension U en continue en fonction du temps t. Ce signal est noté U(t). Ces mesures sont réalisées aux bornes de la batterie ou aux bornes des éléments constituant la batterie.

Ces mesures sont réalisées de façon classique, au moyen de capteurs présents dans les batteries de ce type de véhicule électrifié.

Le procédé est particulièrement intéressant pour étudier une batterie lors de son fonctionnement. Le fonctionnement comprend également les phases de pause du véhicule, à un feu rouge par exemple, caractérisées par un courant nul.

### 2. Transformation des signaux temporels en signaux fréquentiels

Pour transformer les signaux temporels U(t) et I(t), en signaux fréquentiels U(f) et I(f), on réalise un traitement du signal par transformation en série de Fourier. On obtient ainsi des vecteurs dépendants de la fréquence f.

### 3. Calcul de l'impédance électrique complexe du système électrochimique

L'impédance électrique complexe d'un système électrochimique, notée Z(f), est donnée par la relation U=ZI ainsi, Z=U/I.

On a donc :

$$Z(f) = \frac{U(f)}{I(f)}$$

Pour améliorer la précision de l'impédance, on calcule l'impédance en utilisant les densités spectrale de puissance.

La densité spectrale de puissance (DSP) est un outil mathématique permettant de représenter les différentes composantes spectrales d'un signal. Il est égal au carré du module de la transformation de Fourier de X(t), X(f) rapporté à la moitié de la durée d'acquisition T :

$$\Psi_x(f) = \frac{2}{T}\left|X(f)\right|^2 \qquad [2]$$

Il existe également des densités spectrales de puissances croisées qui sont composés de la conjugaison de deux transformations de Fourier X(f) et Y(f) :

$$\Psi_{xy}(f) = \frac{2}{T}X(f)Y^*(f) \qquad [3]$$

$Y^*(f)$ est le conjugué de $Y(f)$

On peut alors exprimer l'impédance électrique complexe du système électrochimique par la relation suivante :

$$Z(f) = \frac{U(f)}{I(f)} = \frac{\frac{2}{T}U(f)I^*(f)}{\frac{2}{T}I(f)I^*(f)} = \frac{\Psi_{IU}(f)}{\Psi_I(f)} \qquad [4]$$

Avec :

$$\Psi_I(f) = \frac{2}{T}|I(f)|^2$$

$$\Psi_{IU}(f) = \frac{2}{T}I^*(f)U(f)$$

Cependant, en pratique, l'application de cette formule n'offre pas une précision suffisante pour déterminer l'impédance.

Selon l'invention, on résout ce problème en segmentant les signaux fréquentiels U(f) et I(f), en N segments. On travaille ensuite indépendamment sur chacun de ces N signaux.

On calcule donc la densité spectrale de puissance $\Psi_I$ et la densité spectrale de puissance croisée $\Psi_{IV}$ sur chacun des N segments.

Puis, on effectue une moyenne des densités spectrales de puissance $\Psi_I$, et une moyenne des densités spectrales de puissance croisée $\Psi_{IV}$

On calcule l'impédance Z(f), en calculant le rapport de ces deux moyennes :

$$Z(f) = \frac{\dfrac{1}{N}\sum_{j=1}^{N}\dfrac{2}{T}U_j(f)\,I_j^*(f)}{\dfrac{1}{N}\sum_{j=1}^{N}\dfrac{2}{T}I_j(f)\,I_j^*(f)} = \frac{\dfrac{1}{N}\sum_{j=1}^{N}\Psi_{UI}(f)}{\dfrac{1}{N}\sum_{j=1}^{N}\Psi_I(f)}$$

Cette segmentation des signaux d'origines en N segments, entraine une diminution des fréquences étudiées, ainsi que des basses fréquences, à cause de la diminution du nombre d'informations traitées à chaque moment. En effet, pour un échantillon de p valeurs mesurées à pas de temps constant, la fréquence est un vecteur comprenant les nombres de 1 à p, divisés par la durée du test. Ainsi, quand on réduit la taille de l'échantillon, on réduit également le nombre de fréquences étudiées, et le nombre de basses fréquences. De plus, selon le théorème de Nyquist-Shannon, *"la fréquence d'échantillonnage d'un signal doit être égale ou supérieure au double de la fréquence maximale contenue dans ce signal, afin de convertir ce signal d'une forme analogique à une forme numérique".* Ainsi, les fréquences les plus hautes doivent être retirées (ce qui diminue d'autant plus le nombre de fréquences d'étude).

Selon l'invention, on peut résoudre ce problème au moyen d'une segmentation particulière des signaux. Afin d'obtenir une impédance ayant une bonne précision sur une plus large partie de la gamme de fréquence, une solution est de traiter plusieurs fois le même signal, mais avec une segmentation différente. Ainsi, des valeurs sur une moyenne importante sont plus précises, et les basses fréquences ont également une précision relative. On réalise donc, plusieurs segmentations. Puis pour chaque segmentation, on travaille indépendamment sur chacun de ces N segments. On calcule donc la densité spectrale de puissance $\Psi_I$ et la densité spectrale de puissance croisée $\Psi_{IV}$ sur chacun des N' segments. Puis, on réalise une nouvelle segmentation, et on recalcule à nouveau des densités spectrales de puissance sur chacun des N' nouveaux segments. Enfin, on effectue une moyenne des densités spectrales de puissance $\Psi_I$, et une moyenne des densités spectrales de puissance croisée $\Psi_{IV}$ sur chacun des N+N'+... segments.

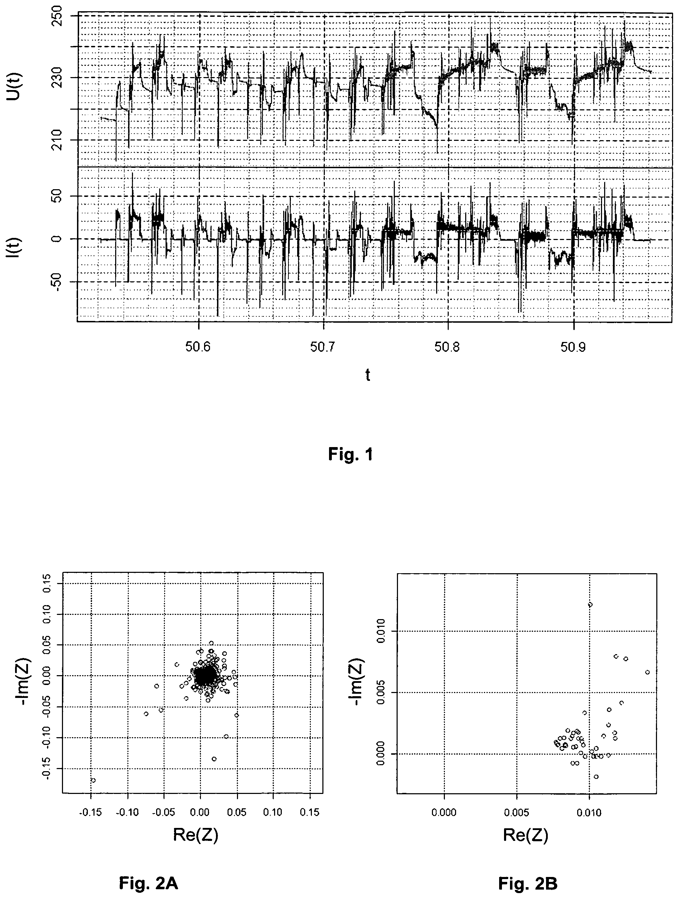

Il existe également une source d'incertitude concernant le signal traité. En effet, il ne s'agit pas d'un bruit blanc. Donc, la densité spectrale de puissance n'est pas constante selon la fréquence, ce qui implique des rapports U(f)/I(f) qui peuvent être très aléatoires (figure 2A).

Selon l'invention, on résout ce problème en appliquant un système de filtre sur les densités spectrales de puissance, afin de sélectionner uniquement les fréquences ayant des densités spectrales de puissance les plus importantes. On peut par exemple utiliser un filtre consistant à définir un seuil S, à déterminer la somme maximale de la densité spectrale de puissance $\Psi_I$ et de la densité spectrale de puissance croisée $\Psi_{IV}$, $(\Psi_I+\Psi_{IV})^{max}=\Psi^{max}$, et à ne sélectionner que les fréquences dont la somme $\Psi_I+\Psi_{IV}$ est supérieure à $\Psi^{max}/S$.

Ainsi, le signal est plus précis, et l'impédance issue du calcul est cohérente par rapport aux impédances effectuées à partir d'une méthode courante.

Ainsi, le procédé de calcul de l'impédance électrique complexe du système électrochimique, à partir de U(f) et I(f), comporte les étapes suivantes :

- On segmente le signal au moins une fois en N segments

- Sur chaque segment on calcule la densité spectrale de puissance $\Psi_I$ ...et la densité spectrale de puissance croisée

$\Psi_{IV}$.

- On calcule l'impédance électrique en calculant le rapport entre la moyenne desdites densités spectrales de puissance croisée sur lesdites densités spectrales de puissance.

On peut également appliquer un système de filtre des densités spectrales de puissance, afin de sélectionner uniquement les fréquences ayant les densités spectrales de puissance les plus importantes.

**Exemple**

Dans cet exemple une batterie de véhicule hybride est cyclée sur un banc de puissance selon un profil routier conventionnel. Ainsi, la batterie subit des accélérations (décharge de batterie), des décélérations avec freinage régénératif (recharge de batterie).
Une batterie de véhicule hybride a une tension nominale de 202V, et une capacité de 6,5Ah. Elle est constituée de 28 éléments de 7,2V, 6,5Ah en série, et chacun de ses éléments est constitué de 6 éléments 1,2V, 6,5Ah, de chimie Ni-MH.

*1. Acquisition de signaux temporels mesurant la tension et le courant*

Sur un banc de puissance cette batterie est rechargée de manière globale, avec une mesure de tension sur chaque élément. Ainsi, les mesures disponibles sont : 1 mesure de l'intensité du courant, et 28 mesures de tension de chacun des éléments.
La détermination des impédances est donc menée sur chacun des éléments de la batterie à partir d'un courant de décharge représentant un signal routier (figure 1).

*2. Transformation des signaux temporels en signaux fréquentiels*

On réalise un traitement du signal par transformation en série de Fourier, pour transformer les signaux temporel en signaux fréquentiels.

*3. Calcul de l'impédance électrique complexe du système électrochimique*

Afin d'obtenir une impédance ayant une bonne précision sur une plus large partie de la gamme de fréquence, on traite plusieurs fois le même signal, mais avec une segmentation de plus en plus faible.
Selon cet exemple, les signaux étudiés comportent 80000 valeurs. On réalise alors une première segmentation de N=5000 segments de 16 valeurs, puis une seconde segmentation de 2500 segments de 32 valeurs... 80000/n segments de n valeurs. n est un entier de type $2^k$, k étant un entier non nul (à cause de l'algorithme de Cooley-Tukey utilisé couramment pour effectuer les transformations de Fourier).
Pour chaque segmentation, on calcule la densité spectrale de puissance $\Psi_I$ et la densité spectrale de puissance croisée $\Psi_{IV}$ sur chaque segment.
On détermine la densité spectrale de puissance $\Psi_I$ maximale $\Psi_I^{max}$, et on sélectionne uniquement les fréquences ayant des densités spectrales de puissance supérieure à $\Psi_I^{max}/10$.
Les figures 2A et 2B illustrent les spectres d'impédance d'un module de batterie de véhicule hybride obtenus à partir d'un signal type routier sans filtre de DSP (figure 2A), et avec filtre de DSP (figure 2B). Sur la figure 2B, les fréquences dont la somme de densités spectrales de puissance $\Psi_{I+}\Psi_{IV}$ est supérieure à $\Psi^{max}/10$ sont sélectionnées.
On calcule alors les impédances électriques de chaque élément de la batterie par la formule suivante, et pour les fréquences sélectionnées :

$$Z(f) = \frac{\dfrac{1}{N}\sum_{j=1}^{N}\Psi_{UI}(f)}{\dfrac{1}{N}\sum_{j=1}^{N}\Psi_{I}(f)}$$

Résultats

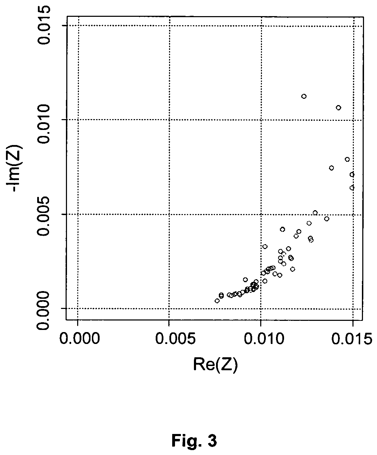

Les impédances obtenues par le procédé selon l'invention sont représentés sur la figure 3. Bien que les mesures soient dispersées, elles sont cohérentes par rapport aux impédances obtenues selon une méthode conventionnelle (par surimposition d'un signal en sinusoïdes).

**Utilisation**

L'impédance électrique complexe d'un système électrochimique de stockage d'énergie électrique, ainsi calculée, est une grandeur complexe. Elle peut être représentée sous la forme d'un diagramme de Nyquist -Im(Z) = F(ReZ) où chaque point correspond à une fréquence.

On distingue ainsi les réponses des phénomènes rapides (résistance interne aux hautes fréquences), des phénomènes intermédiaires, tels que les réactions aux électrodes, et des phénomènes lents (diffusion des ions dans le milieu aux basses fréquences, dites de Warburg).

En calculant ainsi l'impédance, on obtient directement un indicateur pour évaluer l'état interne (état de santé et état de charge) d'une batterie ou d'un de ses éléments.

En effet, l'impédance électrique d'un élément est particulièrement sensible à son état interne (état de charge et état de santé). Durant le fonctionnement, l'état de charge varie rapidement mais pas l'état de santé : ainsi la détermination de l'impédance en fonctionnement reflète l'état de santé d'une batterie et de ses éléments.

De plus, le procédé selon l'invention permet de déterminer l'impédance électrique complexe de chaque élément d'un pack formant une batterie. L'exemple décrit précédemment montre la détermination de l'impédance simultanément sur les 28 éléments (modules) d'une batterie.

Sécurité d'un pack batterie

On peut alors utiliser ces informations afin d'identifier les éléments défectueux du pack dans une batterie complète, et donc d'effectuer la maintenance nécessaire. La défaillance d'un élément, marquée par une dégradation ou une perte du contact électrique, est aisément mise en évidence car son spectre d'impédance diffère des spectres des autres éléments du pack.

Amélioration de la gestion de l'énergie

On peut également utiliser ces informations afin de piloter un système d'équilibrage entre les éléments d'un pack.

Le procédé selon l'invention est applicable à tous les types de système électrochimique, batteries au plomb, Ni-MH, Lithium-polymère et Li-ion...

**Dispositifs**

L'invention concerne également un dispositif pour mettre en oeuvre le procédé selon l'invention pour déterminer l'impédance électrique d'un système électrochimique de stockage d'énergie électrique sans surimposer de signaux supplémentaires au sein du système électrochimique. Ce dispositif comporte :

- un moyen de mesure de la tension U(t) aux bornes du système en fonction du temps t, et lorsque le système est en fonctionnement ;

- un moyen de mesure du courant I(t) aux bornes du système en fonction du temps t, et lorsque le système est en fonctionnement ;

- des moyens logiciels de transformation de Fourier pour transformer les mesures en signaux fréquentiels U(f) et I(f) ;

- des moyens pour réaliser au moins une segmentation des signaux fréquentiels en plusieurs segments ;

- des moyens logiciels de calcul de densité spectrale de puissance du signal de courant $\Psi_I$ et de densité spectrale de puissance croisée des signaux de tension et de courant $\Psi_{IV}$ ; et

- des moyens logiciels de calcul de l'impédance électrique du système électrochimique apte à effectuer un calcul d'un rapport d'une moyenne des densités spectrales de puissance $\Psi_I$ et d'une moyenne des densités spectrales de puissance croisées $\Psi_{IV}$ .

L'invention concerne également un système d'estimation d'un état interne d'un système électrochimique de stockage d'énergie électrique, comportant le dispositif de détermination de l'impédance électrique complexe selon l'invention. Ce système comporte également :

- une mémoire permettant de stocker une relation entre une propriété relative à l'état interne du système électrochimique et l'impédance électrique complexe du système ;

- des moyens pour calculer une propriété relative à l'état interne du système électrochimique au moyen de cette relation.

L'invention concerne également un système intelligent de gestion d'une batterie comportant un système d'estimation d'un état interne de la batterie selon l'invention.

L'invention concerne aussi un véhicule comportant une batterie et un système intelligent de gestion d'une batterie selon l'invention.

Enfin, l'invention concerne aussi un système photovoltaïque de stockage d'énergie électrique, comportant un système d'estimation de son état interne selon l'invention.

## Revendications

1. Procédé de détermination de l'impédance électrique d'un système électrochimique de stockage d'énergie électrique sans surimposer de signaux supplémentaires au sein du système électrochimique, **caractérisé en ce qu'**il comporte les étapes suivantes :

   - on acquiert des signaux temporels mesurant une tension et un courant aux bornes dudit système, et on transforme lesdits signaux temporels en signaux fréquentiels ;
   - on réalise une segmentation desdits signaux fréquentiels en plusieurs segments ;
   - pour chaque segment, on détermine une densité spectrale de puissance du signal de courant $\Psi_I(f)$, et une densité spectrale de puissance croisée des signaux de tension et de courant $\Psi_{IV}(f)$ sur chacun desdits segments, dans chaque segment, lesdites densités spectrales dépendant de la fréquence f ;
   - on détermine l'impédance électrique dudit système électrochimique en calculant le rapport, dépendant de la fréquence f, d'une moyenne desdites densités spectrales de puissance $\Psi_I(f)$ et d'une moyenne desdites densités spectrales de puissance croisées $\Psi_{IV}(f)$.

2. Procédé selon la revendication 1, dans lequel on réalise au moins une deuxième segmentation desdits signaux fréquentiels différente de la première segmentation, de façon à traiter au moins deux fois lesdits signaux fréquentiels.

3. Procédé selon l'une des revendications précédentes, dans lequel on détermine l'impédance électrique dudit système électrochimique uniquement pour des fréquences ayant des densités spectrales de puissance supérieures à un seuil fixé, en appliquant un filtre sur lesdites densités spectrales de puissance $\Psi_I(f)$ et $\Psi_{IV}(f)$.

4. Procédé selon l'une des revendications précédentes, dans lequel on détermine un indicateur pour évaluer un état interne d'une batterie ou d'un de ses éléments, à partir de ladite impédance électrique.

5. Procédé selon l'une des revendications précédentes, dans lequel ledit système électrochimique de stockage d'énergie électrique est un élément d'un pack d'une batterie.

6. Procédé pour identifier des éléments défectueux d'un pack formant une batterie, dans lequel on détermine une impédance électrique de chaque élément dudit pack au moyen du procédé selon la revendication 5, et on compare entre elles lesdites impédances électriques de chacun desdits éléments.

7. Procédé pour piloter un système d'équilibrage entre des éléments d'un pack formant une batterie, dans lequel on détermine une impédance électrique complexe de chaque élément dudit pack au moyen du procédé selon la revendication 5.

8. Procédé selon l'une des revendications précédentes, dans lequel ledit système électrochimique de stockage d'énergie électrique est en fonctionnement.

9. Dispositif pour déterminer l'impédance électrique complexe d'un système électrochimique de stockage d'énergie électrique sans surimposer de signaux supplémentaires au sein du système électrochimique, comportant :

- un moyen de mesure de tension aux bornes dudit système en fonction du temps t ;
- un moyen de mesure de courant aux bornes dudit système en fonction du temps t ;

**caractérisé en ce que** le dispositif comporte de plus:

- des moyens logiciels pour transformer lesdites mesures en signaux fréquentiels ;
- des moyens pour réaliser au moins une segmentation desdits signaux fréquentiels en plusieurs segments ;
- des moyens logiciels de calcul de densité spectrale de puissance du signal de courant $\Psi_I(f)$ et de densité spectrale de puissance croisée des signaux de tension et de courant $\Psi_{IV}(f)$, dans chaque segment lesdites densités spectrales dépendant de la fréquence f ; et
- des moyens logiciels de calcul de l'impédance électrique dudit système électrochimique apte à effectuer un calcul d'un rapport, dépendant de la fréquence f, d'une moyenne desdites densités spectrales de puissance $\Psi_I(f)$ et d'une moyenne desdites densités spectrales de puissance croisées $\Psi_{IV}(f)$.

10. Système d'estimation d'un état interne d'un système électrochimique de stockage d'énergie électrique, comportant :

- un dispositif de détermination de l'impédance électrique complexe d'un système électrochimique de stockage d'énergie électrique selon la revendication 9;
- une mémoire permettant de stocker une relation entre une propriété relative à l'état interne dudit système électrochimique et l'impédance électrique complexe dudit système ;
- des moyens pour calculer une propriété relative à l'état interne dudit système électrochimique au moyen de ladite relation.

11. Système intelligent de gestion d'une batterie comportant un système d'estimation d'un état interne de ladite batterie selon la revendication 10.

12. Véhicule comportant une batterie et un système intelligent de gestion d'une batterie selon la revendication 11.

13. Système photovoltaïque de stockage d'énergie électrique, comportant un système d'estimation de son état interne selon la revendication 10.


**Patentansprüche**

1. Verfahren zum Bestimmen der elektrischen Impedanz eines elektrochemischen Systems zum Speichern elektrischer Energie ohne zusätzliche Signale innerhalb des elektrochemischen Systems einzublenden, **dadurch gekennzeichnet, dass** es die folgenden Schritte umfasst:

- Erfassen von Zeitsignalen, die eine Spannung und einen Strom an den Anschlüssen des Systems messen, und Umwandeln der Zeitsignale in Frequenzsignale;
- Segmentieren der Frequenzsignale in mehrere Segmente;
- für jedes Segment, Bestimmen einer spektralen Leistungsdichte des Stromsignals $\Psi_I(f)$ und einer spektralen Kreuzleistungsdichte der Spannungs- und Stromsignale $\Psi_{IV}(f)$ auf jedem der Segmente in jedem Segment, wobei die Spektraldichten von der Frequenz f abhängig sind;
- Bestimmen der elektrischen Impedanz des elektrochemischen Systems, indem das Verhältnis, in Abhängigkeit von der Frequenz f, eines Mittelwerts der spektralen Leistungsdichten $\Psi_I(f)$ und eines Mittelwerts der spektralen Kreuzleistungsdichten $\Psi_{IV}(f)$ berechnet wird.

2. Verfahren nach Anspruch 1, wobei mindestens eine zweite Segmentierung der Frequenzsignale, die sich von der ersten Segmentierung unterscheidet, durchgeführt wird, um die Frequenzsignale mindestens zweimal zu verarbeiten.

3. Verfahren nach einem der vorhergehenden Ansprüche, wobei die elektrische Impedanz des elektrochemischen Systems nur für Frequenzen bestimmt wird, die spektrale Leistungsdichten aufweisen, die höher als ein festgelegter Schwellenwert sind, indem ein Filter auf die spektralen Leistungsdichten $\Psi_I(f)$ und $\Psi_{IV}(f)$ angewendet wird.

4. Verfahren nach einem der vorhergehenden Ansprüche, wobei aus der elektrischen Impedanz ein Indikator zum Auswerten eines inneren Zustands einer Batterie oder eines ihrer Elemente bestimmt wird.

**5.** Verfahren nach einem der vorhergehenden Ansprüche, wobei das elektrochemische System zum Speichern von elektrischer Energie ein Element eines Batteriesatzes ist.

**6.** Verfahren zum Identifizieren defekter Elemente eines eine Batterie bildenden Satzes, wobei eine elektrische Impedanz jedes Elements des Satzes durch das Verfahren nach Anspruch 5 bestimmt wird und die elektrischen Impedanzen jedes der Elemente verglichen werden.

**7.** Verfahren zum Steuern eines Ausgleichssystems zwischen Elementen eines eine Batterie bildenden Satzes, wobei eine komplexe elektrische Impedanz jedes Elements des Satzes durch das Verfahren nach Anspruch 5 bestimmt wird.

**8.** Verfahren nach einem der vorhergehenden Ansprüche, wobei das elektrochemische System zum Speichern von elektrischer Energie in Betrieb ist.

**9.** Vorrichtung zum Bestimmen der komplexen elektrischen Impedanz eines elektrochemischen Systems zum Speichern elektrischer Energie ohne zusätzliche Signale innerhalb des elektrochemischen Systems einzublenden, umfassend:

- eine Einrichtung zum Messen der Spannung an den Anschlüssen des Systems als Funktion der Zeit t;
- eine Einrichtung zum Messen des Stroms an den Anschlüssen des Systems als Funktion der Zeit t; **dadurch gekennzeichnet, dass** die Vorrichtung außerdem umfasst:
- Software-Einrichtungen zum Umwandeln der Messungen in Frequenzsignale;
- Einrichtungen zum Durchführen mindestens einer Segmentierung der Frequenzsignale in mehrere Segmente;
- Software-Einrichtungen zum Berechnen der spektralen Leistungsdichte des Stromsignals $\Psi_I(f)$ und der spektralen Kreuzleistungsdichte der Spannungs- und Stromsignale $\Psi_{IV}(f)$ in jedem Segment der Spektraldichten, die von der Frequenz f abhängig sind; und
- Software-Einrichtungen zum Berechnen der elektrischen Impedanz des elektrochemischen Systems, das in der Lage ist, ein Verhältnis, abhängig von der Frequenz f, eines Mittelwerts der spektralen Leistungsdichten $\Psi_I(f)$ und eines Mittelwerts der spektralen Kreuzleistungsdichten $\Psi_{IV}(f)$ zu berechnen.

**10.** System zum Bewerten eines inneren Zustands eines elektrochemischen Systems zum Speichern elektrischer Energie, umfassend:

- eine Vorrichtung zum Bestimmen der komplexen elektrischen Impedanz eines elektrochemischen Systems zum Speichern elektrischer Energie nach Anspruch 9;
- ein Speicher zum Speichern einer Beziehung zwischen einer Eigenschaft, die sich auf den inneren Zustand des elektrochemischen Systems bezieht, und der komplexen elektrischen Impedanz des Systems;
- Einrichtungen zum Berechnen einer Eigenschaft, die sich auf den inneren Zustand des elektrochemischen Systems bezieht, die die Beziehung verwenden.

**11.** Intelligentes Batteriemanagementsystem, umfassend ein System zum Bewerten eines inneren Zustands der Batterie nach Anspruch 10.

**12.** Fahrzeug, umfassend eine Batterie und ein intelligentes Batteriemanagementsystem nach Anspruch 11.

**13.** Photovoltaiksystem zum Speichern elektrischer Energie, umfassend ein System zum Bewerten seines inneren Zustands nach Anspruch 10.

**Claims**

**1.** A method of determining the electrical impedance of an electrochemical system for electric power storage without superimposing additional signals within the electrochemical system, **characterized in that** it comprises the following stages:

- acquiring time signals measuring a voltage and a current at the terminals of said system, and converting said time signals to frequency signals,
- carrying out a segmentation of said frequency signals into several segments,

- for each segment, determining a power spectral density of the current signal $\Psi_I(f)$ and the cross power spectral density of the voltage and current signals $\Psi_{IV}(f)$ on each one of said segments, in each segment, said spectral densities depending on frequency f,

- determining the electrical impedance of said electrochemical system by calculating the ratio, depending on frequency f, of a mean of said power spectral densities $\Psi_I(f)$ to a mean of said cross power spectral densities $\Psi_{IV}(f)$.

2. A method as claimed in claim 1, wherein at least a second segmentation of said frequency signals, different from the first segmentation, is carried out so as to process said frequency signals at least twice.

3. A method as claimed in any one of the previous claims, wherein the electrical impedance of said electrochemical system is determined only for frequencies having power spectral densities above a set threshold, by applying a filter to said power spectral densities $\Psi I(f)$ and $\Psi IV(f)$.

4. A method as claimed in any one of the previous claims, wherein an indicator is determined in order to evaluate an internal state of a battery or of one of its elements, from said electrical impedance.

5. A method as claimed in any one of the previous claims, wherein said electrochemical system for electric power storage is an element of a battery pack.

6. A method for identifying defective parts of a pack forming a battery, wherein an electrical impedance of each element of said pack is determined by means of the method as claimed in claim 5, and the electrical impedances of each one of said elements are compared with one another.

7. A method for driving a balancing system between elements of a pack forming a battery, wherein a complex electrical impedance of each element of said pack is determined by means of the method as claimed in claim 5.

8. A method as claimed in any one of the previous claims, wherein said electrochemical system for electric power storage is in operation.

9. A device for determining the complex electrical impedance of an electrochemical system for electric power storage without superimposing additional signals within the electrochemical system, comprising:

- a means for measuring the voltage at the terminals of said system as a function of time t,
- a means for measuring the current at the terminals of said system as a function of time t,

**characterized in that** the device further comprises:

- software for converting said measurements to frequency signals,
- means for carrying out at least one segmentation of said frequency signals to several segments,
- software for computing the power spectral density of the current signal $\Psi_I(f)$ and the cross power spectral density of the voltage and current signals $\Psi_{IV}(f)$ in each segment, said spectral densities depending on frequency f, and
- software for computing the electrical impedance of said electrochemical system suited to compute a ratio, depending on frequency f, of a mean of said power spectral densities $\Psi_I(f)$ to a mean of said cross power spectral densities $\Psi_{IV}(f)$.

10. A system of estimating an internal state of an electrochemical system for electric power storage, comprising:

- a device for determining the complex electrical impedance of an electrochemical system for electric power storage as claimed in claim 9,
- a memory allowing to store a relation between a property relative to the internal state of said electrochemical system and the complex electrical impedance of said system,
- means for computing a property relative to the internal state of said electrochemical system by means of said relation.

11. A smart battery management system comprising a system for estimating an internal state of said battery as claimed in claim 10.

12. A vehicle comprising a battery and a smart battery management system as claimed in claim 11.

13. A photovoltaic system for electric power storage, comprising a system for estimating its internal state as claimed in claim 10.

**Fig. 1**

**Fig. 2A**

**Fig. 2B**

**Fig. 3**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070257681 A1

**Littérature non-brevet citée dans la description**

- **BLANKE H ; BOHLEN O ; BULLER S ; DE DON-CKER R W ; FRICKE B ; HAMMOUCHE A ; LINZEN D ; THELE M ; SAUER D U.** *Impedance measurements on lead-acid batteries for state-of-charge, state-of-health and cranking capability prognosis in electric and hybrid electric vehicles*